(19) Europäisches Patentamt
European Patent Office
Office européen des brevets

(11) **EP 3 835 835 B1**

(12) **FASCICULE DE BREVET EUROPEEN**

(45) Date de publication et mention de la délivrance du brevet:
**13.11.2024 Bulletin 2024/46**

(21) Numéro de dépôt: **20211732.1**

(22) Date de dépôt: **04.12.2020**

(51) Classification Internationale des Brevets (IPC):
**G01V 20/00** (2024.01)   G06F 30/20 (2020.01)

(52) Classification Coopérative des Brevets (CPC):
**G01V 20/00;** G01V 2210/661; G06F 30/20

(54) **PROCEDE POUR METTRE A JOUR UN MODELE STRATIGRAPHIQUE D'UN BASSIN SEDIMENTAIRE EN FONCTION DE MESURES**

VERFAHREN ZUR AKTUALISIERUNG EINES STRATIGRAPHISCHEN MODELLS EINES SEDIMENTBECKENS AUF DER GRUNDLAGE VON MESSUNGEN

METHOD FOR UPDATING A STRATIGRAPHIC MODEL OF A SEDIMENTARY BASIN ACCORDING TO MEASUREMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.12.2019 FR 1914308**

(43) Date de publication de la demande:
**16.06.2021 Bulletin 2021/24**

(73) Titulaire: **IFP Energies nouvelles
92852 Rueil-Malmaison Cedex (FR)**

(72) Inventeurs:
• **MALINOUSKAYA, Iryna
92852 RUEIL-MALMAISON CEDEX (FR)**
• **RASOLOFOSAON, Patrick
92852 RUEIL-MALMAISON CEDEX (FR)**
• **GERVAIS-COUPLET, Veronique
92852 RUEIL-MALMAISON CEDEX (FR)**
• **GRANJEON, Didier
92852 RUEIL-MALMAISON CEDEX (FR)**

(74) Mandataire: **IFP Energies nouvelles
Département Propriété Industrielle
Rond Point de l'échangeur de Solaize
BP3
69360 Solaize (FR)**

(56) Documents cités:
**EP-A1- 2 447 467    EP-A1- 3 104 199**
**EP-A1- 3 106 900    WO-A2-2020/123099**
**US-A- 4 679 174**

• **RAFAEL SOUZA ET AL: "Analysis of time-lapse seismic and production data for reservoir model classification and assessment", JOURNAL OF GEOPHYSICS AND ENGINEERING, INSTITUTE OF PHYSICS PUBLISHING, BRISTOL, GB, vol. 15, no. 4, 9 May 2018 (2018-05-09), pages 1561 - 1587, XP020329341, ISSN: 1742-2140, [retrieved on 20180509], DOI: 10.1088/1742-2140/AAB287**
• **BAUR FRIEDEMANN ET AL: "Some practical guidance for petroleum migration modeling", MARINE AND PETROLEUM GEOLOGY, vol. 93, 1 May 2018 (2018-05-01), AMSTERDAM, NL, pages 409 - 421, XP093021955, ISSN: 0264-8172, Retrieved from the Internet <URL:https://www.sciencedirect.com/science/article/pii/S0098300408001349/pdfft?md5=4e5dec7db03c3eb81e599aa565378582&pid=1-s2.0-S0098300408001349-main.pdf> [retrieved on 20230208], DOI: 10.1016/j.marpetgeo.2018.03.003**
• **SCHLUMBERGER 2012 ET AL: "User Guide PetroMod petroleum systems modeling software", 1 January 2012 (2012-01-01), XP093021982, Retrieved from the Internet <URL:https://dvikan.no/ntnu-studentserver/reports/PetroMod_2012_2_PetroReport_UserGuide.pdf> [retrieved on 20230208]**

# EP 3 835 835 B1

## Description

## Domaine technique

La présente invention concerne le domaine de l'exploration et de l'exploitation des gisements pétroliers ou de sites de stockage géologique de gaz. La présente invention concerne également le domaine des énergies nouvelles telles que la géothermie ou le stockage d'énergie dans le sous-sol. De manière générale, la présente invention peut être utilisée dans tout domaine nécessitant une caractérisation de la géométrie et de la nature des couches sédimentaires composant le sous-sol.

L'exploration pétrolière consiste à rechercher des gisements d'hydrocarbures au sein d'un bassin sédimentaire. La compréhension des principes de la genèse des hydrocarbures et leurs liens avec l'histoire géologique du sous-sol, a permis la mise au point de méthodes d'évaluation du potentiel pétrolier d'un bassin sédimentaire. La démarche générale de l'évaluation du potentiel pétrolier d'un bassin sédimentaire comporte des allers-retours entre une prédiction du potentiel pétrolier du bassin sédimentaire, réalisée à partir d'informations mesurées relatives au bassin étudié (analyse d'affleurements, campagnes sismiques, forages par exemple), et des forages d'exploration dans les différentes zones présentant le meilleur potentiel, afin de confirmer ou infirmer le potentiel prédit préalablement, et d'acquérir de nouvelles informations permettant de préciser les prédictions de potentiel pétrolier du bassin étudié.

L'exploitation pétrolière d'un gisement consiste, à partir des informations récoltées lors de la phase d'exploration pétrolière, à sélectionner les zones du gisement présentant le meilleur potentiel pétrolier, à définir des schémas d'exploitation pour ces zones (par exemple à l'aide d'une simulation de réservoir, afin de définir les nombre et positions des puits d'exploitation permettant une récupération d'hydrocarbures maximale), à forer des puits d'exploitation et, de façon générale, à mettre en place les infrastructures de production nécessaires au développement du gisement.

L'évaluation du potentiel pétrolier d'un bassin sédimentaire peut se faire soit de manière probabiliste soit de manière analytique. L'approche analytique est le plus souvent mise en œuvre au moyen de logiciels exécutés sur ordinateur, permettant la synthèse des données disponibles et la simulation de l'histoire géologique du bassin étudié. En fonction de la complexité de l'histoire géologique du bassin étudié, la famille des logiciels mis en oeuvre pour l'approche analytique peut comprendre la simulation à une, deux ou trois dimensions, des processus sédimentaires, tectoniques, thermiques, hydrodynamiques, de chimie organique et inorganique qui interviennent lors de la formation d'un bassin pétrolier. On parle alors d'une démarche dite de « modélisation de bassin ».

Concernant plus particulièrement la modélisation des processus sédimentaires, on met en oeuvre des logiciels dits de modélisation stratigraphique ou encore de simulation stratigraphique. La modélisation stratigraphique a pour objectif de simuler l'évolution d'un bassin sédimentaire au cours des temps géologiques afin de quantifier notamment la géométrie des couches sédimentaires, le type de sédiments déposés, la profondeur d'eau au moment du dépôt, etc. On connaît des modèles stratigraphiques 3D, résolus de manière numérique, via des logiciels exécutés sur ordinateur, tels que le simulateur stratigraphique DIONISOS FLOW® (IFP Energies nouvelles, France).

De manière générale, une simulation stratigraphique utilise un ensemble d'équations décrivant les processus physiques intervenant dans la formation des bassins sédimentaires, dont la résolution permet d'obtenir une suite de modèles stratigraphiques représentant l'architecture et la composition des couches sédimentaires du sous-sol d'un bassin sédimentaire. Une simulation stratigraphique nécessite la définition de la topographie du bassin à l'âge de début de l'unité stratigraphique étudiée la plus ancienne. Puis, la simulation calcule la répartition de la quantité et de la composition des sédiments érodés, déplacés ou déposés dans le bassin au cours du temps en fonction des apports de sédiments (e.g. apport fluviatile ou production carbonatée), de la capacité des sédiments à être transportés dans le bassin, et de la déformation du bassin (e.g. tectonique, variations du niveau de la mer ou des lacs, compaction).

A l'issue d'une simulation stratigraphique, on obtient un modèle stratigraphique sous la forme d'une représentation numérique du bassin étudié. La représentation numérique du bassin se présente généralement sous la forme d'une grille ou d'un maillage représentant la structure des couches sédimentaires déposées dans le bassin. Chaque maille de la grille est également caractérisée par la composition des sédiments qui y sont déposés et par l'environnement de dépôt.

Le résultat d'une simulation stratigraphique est directement fonction des paramètres d'entrée de la simulation, tels que la bathymétrie initiale, les coefficients de transport de sédiment ou les apports en sédiments. Or ces paramètres d'entrée de la simulation stratigraphique ne sont le plus souvent pas connus de manière exacte. En effet, on procède généralement à une estimation de ces paramètres, à partir de différentes mesures réalisées in situ. Ainsi, la bathymétrie initiale peut être estimée par une interprétation en environnements de dépôt (fluvial, littoral, marin profond...) de données de puits et de données sismiques ; les coefficients de transport peuvent être définis à partir des environnements sédimentaires modernes (c'est-à-dire observés au temps actuel), en comparant par exemple le flux de sédiment transporté par les fleuves au débit de ces fleuves ; quant aux apports de sédiments, ils peuvent être évalués à partir du volume de sédiments déposés dans la zone d'étude. Ainsi, les paramètres de la simulation stratigraphique ne résultent pas d'une mesure directe, mais d'une interprétation de mesures réalisées in situ.

2

Par conséquent, si les paramètres d'entrée ne sont pas exacts, le résultat de la simulation stratigraphique n'est lui-même pas représentatif de la véritable stratigraphie du bassin étudié. Afin de pouvoir être utilisé pour caractériser le sous-sol d'un bassin sédimentaire, un modèle stratigraphique ne sera représentatif de ce bassin que s'il est cohérent avec les différentes informations disponibles sur ce bassin, et au moins les informations diagraphiques mesurées le long d'un puits d'exploration (renseignant par exemple sur le type de roches ou sur la porosité des couches sédimentaires rencontrées le long du puits) et les informations résultant de campagnes sismiques 2D ou 3D (renseignant par exemple sur la géométrie des couches sédimentaires constituant le bassin sédimentaire, et éventuellement sur le type de dépôt). Ainsi, la valeur des paramètres d'entrée de la simulation stratigraphique doit être mise à jour pour que le modèle stratigraphique obtenu soit le plus cohérent possible avec les mesures réalisées sur le bassin. Par la suite, on appelle "données observées" ou encore tout simplement "données" les mesures réalisées sur le bassin permettant de valider un modèle stratigraphique.

**Technique antérieure**

Les documents suivants seront cités dans la suite de la description :

L. Saiida, D. Guérillot (1998) Méthode pour former automatiquement un modèle simulant la structure stratigraphique d'une zone souterraine. Brevet 2776393.
K. Charvin, K. Gallagher, G. L. Hampson, R. Labourdette (2009) A Bayesian approach to inverse modeling of stratigraphy, part 1: method. Basin Research, 21, 5-25.
O. Falivene, A. Frascati, S. Gesbert, J. Pickens, Y. Hsu, A. Rovira (2014) Automatic calibration of stratigraphic forward models for predicting réservoir présence in exploration. AAPG Bulletin, 98(9), 1811-1835.
E. Baudrier, G. Millon, F. Nicolier, S. Ruan (2008) Binary image comparison with local dissimilarity quantification. Pattern Recognition, 41(5), 1461-1478.
C.-H. Koeck, G. Bourdarot, G. Al-Jefri, F. H. Nader, R. Richet, A. Barrois (2015) Improving a numerical sequence stratigraphic model through a global sensitivity analysis; Giant Carbonate Offshore Field, Abu Dhabi. SPE-177758-MS, Abu Dhabi International Petroleum Exhibition and Conférence, Abu Dhabi, UAE, 9-12 November 2015.
T. Duan (2017) Similarity measure of sedimentary successions and its application in inverse stratigraphie modeling. Pet. Sci., 14, 484-492.
I. S. Molchanov, P. Teran (2003) Distance transforms for real-valued functions. J. Math. Anal. Appl., 278, 472-484.
D. McKay (2003) Information theory, inference and learning algorithms. Cambridge University Press, ISBN 0-521-64298-1.
Ng A.Y., Jordan M.I. and Weiss Y. (2002) On spectral clustering: Analysis and an algorithm. In: Advances in Neural Information Processing Systems 14, Vols 1 and 2, 849-856.
Kohonen T. (2001) Self-Organizing Maps. Springer, Berlin, 525 p.
Grus J. (2016), K-means and hierarchical clustering with Python, O'Reilly, ISBN: 9781491965306.
D. Sinoquet, F. Delbos (2008) Adapted nonlinear optimization method for production data and 4D seismic inversion. Proceedings of ECMOR XI conférence, Bergen, Norway, September 2008.
D.R. Jones, M. Schonlau, W.J. Welch (1998) Efficient Global Optimization of Expensive Black-Box Functions. Journal of Global Optimization, 13, 455-492.

On connait des procédés pour mettre à jour un modèle stratigraphique en fonction de données observées pour des propriétés continues, basés sur des formulations d'erreur quantifiant la différence entre ces données et les valeurs simulées correspondantes. Par exemple, dans le document (Saiida *et al.*, 1998), la fonction objectif est définie comme la somme des différences au carré entre épaisseurs de sédiments simulées et mesurées dans chaque couche le long d'un puits. Cette formulation est également utilisée dans le document (Charvin *et al.*, 2009) pour reproduire la répartition des tailles de grain le long des puits ainsi qu'un profil d'épaisseur totale de sédiments déposés dans une section du bassin (épaisseur totale dans chaque colonne). Enfin, le document (Falivene *et al.*, 2014) considère la somme des différences en valeur absolue entre données simulées et données mesurées dans chaque maille pour estimer l'erreur sur une carte (x,y) des épaisseurs totales. Ces approches, dites de comparaison maille à maille, cherchent donc à reproduire exactement toutes les données en considérant la somme des erreurs sur chaque donnée et en minimisant cette somme d'erreurs. De telles approches ont pour effet de trouver une solution pour laquelle la moyenne des erreurs est minimisée. Cela a pour conséquence qu'il peut exister plusieurs modèles caractérisés par la même moyenne des erreurs, mais avec une répartition spatiale des erreurs différentes.

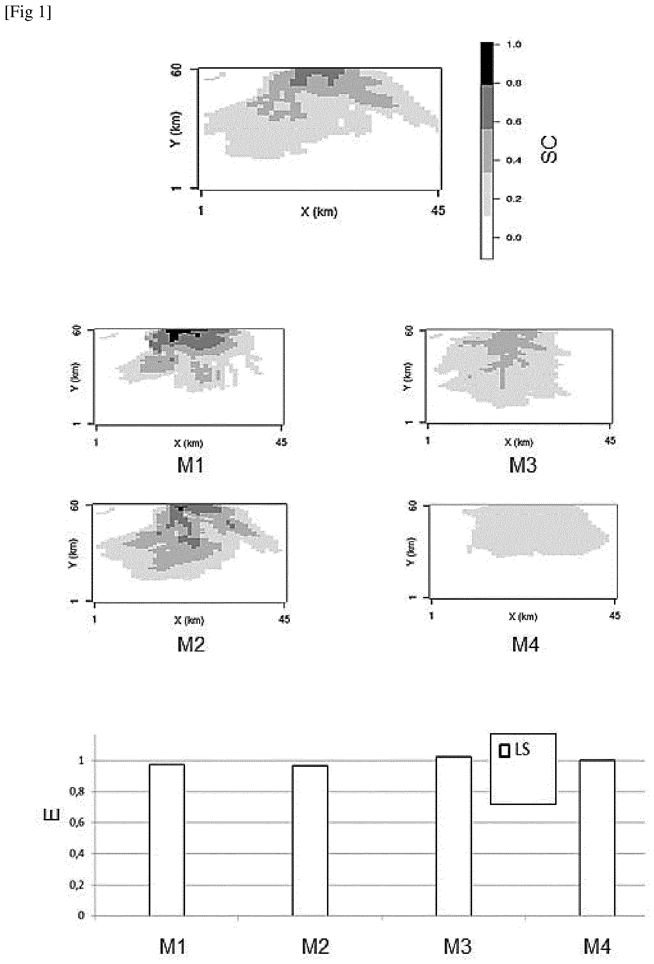

C'est ce qui est illustré sur la figure 1. Plus précisément, la figure 1 en haut présente une carte de concentration en sable SC observée (appelé "modèle de référence" par la suite), c'est-à-dire celle que l'on cherche à reproduire. Les quatre figures centrales de la figure 1 présentent des exemples de cartes de concentration en sable simulées, notées M1, M2, M3 et M4 (appelées "modèles simulés" par la suite), obtenus en modifiant certaines caractéristiques du modèle de référence (paramètres d'entrée). La figure 1 en bas présente un histogramme dont les colonnes LS en blanc représentent la somme normalisée, sur l'ensemble des mailles, de la différence au carré entre la concentration en sable observée et la concentration en sable simulée pour chacun des modèles simulés M1, M2, M3 et M4. Autrement dit, chaque colonne LS représente l'erreur E entre le modèle de référence et les modèles simulés calculée par une comparaison maille à maille des données mesurées et simulées. Comme on peut le constater sur cette figure, les modèles simulés M1, M2, M3 et M4 sont très différents les uns des autres, certains reproduisant mieux la localisation des chenaux observés sur le modèle de référence que d'autres, alors que l'erreur E associée est très proche (les hauteurs des colonnes LS des histogrammes relatifs aux modèles simulés M1, M2, M3, et M4 sont similaires). Par conséquent, une fonction coût basée sur la somme des erreurs maille à maille entre données mesurées et simulées ne suffit pas nécessairement pour classer correctement des modèles stratigraphiques quant à la représentativité des variations spatiales des propriétés par rapport à leurs variations spatiales réelles.

Par ailleurs, les données que l'on cherche à reproduire peuvent être incertaines, et il n'est pas forcément pertinent de chercher à reproduire exactement la distribution de ces valeurs. Ces incertitudes sont liées tout d'abord aux erreurs de mesure. De plus, les données sont généralement acquises à des résolutions plus fines que celles considérées pour la simulation stratigraphique. Enfin, les données peuvent résulter d'un traitement des mesures (c'est le cas notamment des données sismiques, qui subissent nécessairement un traitement sismique avant de pouvoir être exploitées), ce qui introduit des incertitudes supplémentaires. Ainsi, il n'est pas nécessairement souhaitable de chercher à reproduire de manière précise des données qui s'avèrent incertaines.

Enfin, se pose la difficulté de la comparaison de données discrètes comme les faciès. On connaît deux documents introduisant des techniques de comparaison de successions de faciès 1D. Le document (Koeck *et al.,* 2015) considère une succession de faciès de référence et une succession de faciès simulés sur une même grille de discrétisation en temps géologique (celle de la simulation). L'écart entre les deux successions est ensuite défini via la somme dans chaque maille de la valeur absolue de la différence entre l'indice du faciès observé et l'indice du faciès simulé. A ce terme d'erreur est ajoutée la valeur absolue de la différence entre l'épaisseur de la séquence observée et l'épaisseur de la séquence simulée. Cette approche se base toutefois sur les indices associés à chaque faciès qui n'ont pas de sens physique (ce sont des propriétés catégorielles). L'erreur calculée ici est donc dépendante du choix de ces indices. Le document (Duan, 2017) considère quant à lui les deux successions de faciès à comparer comme des chaînes de couples {indice du faciès, épaisseur}, et utilise une approche syntaxique pour comparer ces chaînes : leur dissimilarité est quantifiée selon le nombre d'opérations de continuation, insertion et substitution nécessaires pour passer d'une chaîne à l'autre.

On connaît en outre les documents suivants :

- Rafael Souza, David Lumley, Jeffrey Shragge, Alessandra Davolio, Denis José Schiozer, Analysis of time-lapse seismic and production data for réservoir model classification and assessment, Journal of Geophysics and Engineering, Volume 15, Issue 4, August 2018, Pages 1561-1587, https://doi.org/10.1088/1742-2140/aab287", qui concerne une analyse de données sismiques et de données de production pour la classification et l'évaluation d'un modèle de réservoir ;
- EP 2447467 A1, qui concerne un procédé d'exploitation d'un gisement pétrolier à partir d'un calage d'historique de données de production et de données sismiques ;
- US 4679174 A, qui concerne un procédé de création d'un modèle lithologique d'une partie du sous-sol terrestre à partir de données sismiques ;
- Baur, Friedemann & Katz, Barry. (2018). Some practical guidance for petroleum migration modeling. Marine and Petroleum Geology. 93. 10.1016/j.marpetgeo.2018.03.003 ;
- Schlumberger el al., 2012, "User guide Petromod petroleum systems modeling software", (2012-01-01) ;
- EP3016900 A1, qui concerne un procédé pour un raffinement de temps géologique.

EP 3 104 199 A1 divulgue une méthode informatique pour l'exploitation du pétrole d'un bassin sédimentaire, qui nécessite un simulateur stratigraphique, c'est-à-dire un logiciel conçu pour reconstruire les processus sédimentaires qui ont affecté le bassin depuis un temps géologique t jusqu'à aujourd'hui. La simulation de l'histoire sédimentaire d'un bassin nécessite le développement de systèmes d'équations permettant d'estimer : (1) l'évaluation de l'espace disponible pour la sédimentation, liée aux mouvements tectoniques et/ou eustatiques, (2) l'apport de sédiments dans le bassin, soit à travers les frontières, soit par production in situ ou précipitation, (3) le transport de ces sédiments dans l'espace disponible créé, (4) l'évolution de ces sédiments au cours de l'enfouissement, c'est-à-dire la diagenèse.

La présente invention vise à pallier ces inconvénients. Notamment, la présente invention vise à reproduire les données mesurées relatives à une propriété en identifiant l'emplacement de zones ayant des valeurs proches pour cette propriété (comme par exemple les chenaux caractérisés par une certaine gamme de proportion de sable). Pour ce faire, le procédé selon l'invention repose notamment sur une ré-organisation des données en classes, le niveau de résolution du modèle obtenu par rapport aux données mesurées pouvant être fonction de l'intervalle de valeurs choisies pour chaque classe. Autrement dit, le procédé selon l'invention permet d'extraire des caractéristiques discriminantes des données (zones ayant une cohérence géologique) et vise à retrouver ces caractéristiques. De plus, la présente invention permet de traiter les faciès comme des données catégorielles, c'est-à-dire comme des objets géologiques dont on cherche à retrouver l'emplacement.

De plus, la présente invention permet d'une certaine manière de tenir compte des incertitudes sur les données continues. En effet, on ne cherche pas ici à caler exactement la donnée continue fournie maille à maille, mais plutôt une donnée dégradée informant sur les grandes tendances, ici l'emplacement de zones d'intérêt définies à partir des données. Ainsi, on va chercher à reproduire par exemple la forme des chenaux définie par une concentration ou épaisseur de sable suffisamment grande, mais pas la répartition exacte des concentrations ou hauteur de sable dans cette zone.

De plus, la présente invention peut permettre de traiter de façon simultanée la géométrie des couches du bassin et les propriétés des sédiments dans ces couches. En effet, si les données à caler dépendent de la profondeur (données de puits par exemple), on peut intégrer dans la fonction coût à la fois un terme d'erreur sur la profondeur et un terme d'erreur sur la propriété des sédiments.

**Résumé de l'invention**

La présente invention concerne un procédé mis en oeuvre par ordinateur pour mettre à jour un modèle stratigraphique d'un bassin sédimentaire en fonction de mesures réalisées sur ledit bassin selon la revendication 1. Le procédé selon l'invention comprend au moins les étapes suivantes :

A) On réalise des mesures de grandeurs physiques relatives audit bassin au moyen de capteurs, lesdites mesures comprenant au moins des mesures diagraphiques et des mesures sismiques ;

B) A partir desdites mesures, on détermine au moins une première distribution spatiale de valeurs d'un attribut représentatif de ladite stratigraphie dudit bassin, et on détermine une première image classifiée relative à ladite première distribution spatiale au moyen d'une méthode de classification pour regrouper lesdites valeurs dudit attribut de ladite première distribution spatiale en au moins deux classes ;

C) Au moyen de ladite simulation stratigraphique exécutée avec lesdites valeurs desdits paramètres de ladite simulation, on détermine un modèle stratigraphique ;

D) On en déduit au moins une deuxième distribution spatiale de valeurs dudit attribut représentatif de ladite stratigraphie dudit bassin, et on détermine une deuxième image classifiée relative à ladite deuxième distribution spatiale au moyen de ladite méthode de classification pour regrouper lesdites valeurs dudit attribut de ladite deuxième distribution spatiale selon lesdites au moins deux classes de ladite première image classifiée ;

E) On détermine une distribution de dissimilarités locales entre lesdites première et deuxième images classifiées, et on modifie une valeur d'au moins un desdits paramètres de ladite simulation stratigraphique de façon à minimiser une fonction objectif formée à partir d'au moins ladite distribution desdites dissimilarités locales ;

F) On met à jour ledit modèle stratigraphique en répétant au moins l'étape C) avec lesdites valeurs desdits paramètres de simulation modifiées.

Selon une mise en oeuvre de l'invention, on peut mettre à jour ledit modèle stratigraphique à l'étape F) en répétant la séquence des étapes C), D) et E) jusqu'à ce que ladite fonction objectif satisfasse au moins un critère prédéfini.

Selon une mise en oeuvre de l'invention, lorsque ladite deuxième distribution spatiale desdites valeurs dudit attribut est définie sur un support spatial différent du support spatial de ladite première distribution spatiale desdites valeurs dudit attribut, on peut rééchantillonner au moins ladite deuxième distribution spatiale desdites valeurs dudit attribut de manière à ce que lesdites première et deuxième distributions spatiales desdites valeurs dudit attribut soient définies sur un support spatial identique.

Selon une mise en oeuvre de l'invention, ladite fonction objectif peut être formée à partir au moins d'une somme pondérée desdites dissimilarités locales au carré observées en chacun des pixels desdites première et deuxième images classifiées.

Selon une mise en oeuvre de l'invention, ladite fonction objectif peut comprendre en outre un terme d'erreur lié audit rééchantillonnage d'au moins ladite deuxième distribution spatiale desdites valeurs dudit attribut

Selon une mise en oeuvre de l'invention, ledit attribut représentatif de ladite stratigraphie peut être choisi parmi le faciès lithologique, l'épaisseur d'une unité stratigraphique, la concentration moyenne en sable dans une unité stratigraphique, la concentration moyenne en argile dans une unité stratigraphique.

Selon une mise en oeuvre de l'invention, ladite méthode de classification peut être choisie parmi : la méthode K-means, la méthode du partitionnement spectral, la méthode des cartes auto-organisatrices, ou encore la méthode par regroupement hiérarchique.

Selon une mise en oeuvre de l'invention, on peut utiliser la distance de Hausdorff pour déterminer ladite distribution des dissimilarités locales.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé tel que décrit ci-dessus, lorsque ledit programme est exécuté sur un ordinateur.

L'invention concerne également un procédé pour exploiter des hydrocarbures présents dans un bassin sédimentaire, ledit procédé comprenant au moins la mise en oeuvre du procédé pour mettre à jour ledit modèle stratigraphique dudit bassin tel que décrit ci-dessus, et dans lequel, à partir au moins dudit modèle stratigraphique mis à jour, on détermine un schéma d'exploitation dudit bassin comprenant au moins une implantation d'au moins un puits injecteur et/ou d'au moins un puits producteur, et on exploite lesdits hydrocarbures dudit bassin au moins en forant lesdits puits de ladite implantation et en les équipant d'infrastructures d'exploitation.

D'autres caractéristiques et avantages du procédé selon l'invention, apparaîtront à la lecture de la description ci-après d'exemples non limitatifs de réalisations, en se référant aux figures annexées et décrites ci-après.

**Liste des figures**

La figure 1 illustre une mise à jour d'un modèle stratigraphique par un procédé selon l'art antérieur.

La Figure 2 illustre un exemple de représentation maillée d'un bassin sédimentaire en vue tridimensionnelle.

La Figure 3 illustre une étape optionnelle de rééchantillonnage entre des données mesurées et des données simulées pour la mise en oeuvre du procédé selon le premier aspect de l'invention.

La Figure 4 illustre l'étape de classification du procédé selon le premier aspect de l'invention.

La Figure 5 illustre un exemple d'une représentation d'un bassin sédimentaire construite à partir de mesures sismiques et de mesures diagraphiques réalisées en trois puits.

Les Figures 6 et 7 illustrent des résultats de la mise en oeuvre du procédé selon le premier aspect de l'invention, dans le cas où la propriété à retrouver est un faciès sédimentaire.

La Figure 8 illustre un exemple d'une représentation d'un bassin sédimentaire construite à partir de mesures sismiques et de mesures diagraphiques, ainsi que la distribution spatiale de la concentration en sable pour chaque colonne de cette représentation maillée.

La Figure 9 illustre des résultats de la mise en oeuvre du procédé selon le premier aspect de l'invention dans le cas où la propriété à retrouver est une concentration en sable.

**Description des modes de réalisation**

Selon un premier aspect, l'invention concerne un procédé mis en oeuvre par ordinateur pour mettre à jour un modèle stratigraphique d'un bassin sédimentaire en fonction de mesures réalisées sur le bassin.

Selon un deuxième aspect, l'invention concerne un procédé pour exploiter des hydrocarbures présents dans un bassin sédimentaire, le procédé selon le deuxième aspect comprenant la mise en oeuvre du procédé pour mettre à jour un modèle stratigraphique d'un bassin sédimentaire selon le premier aspect de l'invention.

Le procédé selon le premier aspect de l'invention comprend au moins les étapes 1 à 7 décrites ci-après, suivies d'au moins une répétition de l'étape 3. Selon une variante principale de l'invention, à l'issue d'une première application des étapes 1 à 7, les étapes 3 à 7 sont au moins réitérées une fois.

Le procédé selon le deuxième aspect de l'invention comprend en outre au moins l'étape 8 décrite ci-après.

**1) Mesures de grandeurs physiques relatives au bassin**

Au cours de cette étape, on réalise des mesures de grandeurs physiques relatives au bassin au moyen de capteurs, les mesures comprenant au moins des mesures diagraphiques et des mesures sismiques.

Par mesures diagraphiques, on entend des mesures réalisées dans au moins un puits foré dans un bassin, au moyen d'un dispositif ou sonde diagraphique se déplaçant le long du puits pour mesurer une grandeur physique relative à la formation géologique proche du puits. Les mesures diagraphiques permettent d'estimer par exemple le contenu en eau et en hydrocarbures à chaque pas de mesure dans le puits, la lithologie dominante (ou faciès lithologique) et notamment le contenu en sable et/ou en argile des roches traversées, mais également le pendage et l'épaisseur des couches. Selon une mise en oeuvre de l'invention, les grandeurs physiques mesurées peuvent comprendre la résistivité électrique, la radioactivité gamma naturelle, la polarisation spontanée. La mesure diagraphique est une mesure locale, le long du puits et d'extension latérale limitée.

Par mesures sismiques, on entend des mesures réalisées au moyen d'un dispositif d'acquisition de mesures sismiques, comprenant de manière classique au moins une source sismique (par exemple un canon à eau en sismique marine, ou un camion vibrateur en sismique terrestre) pour générer des ondes sismiques dans le bassin et une pluralité de récepteurs d'ondes sismiques (tels que des accéléromètres, des hydrophones) placés de manière à enregistrer au moins des ondes sismiques s'étant réfléchies sur des contrastes d'impédance du bassin (tels que des surfaces d'érosion, des limites d'unités stratigraphiques). De manière classique le dispositif d'acquisition sismique est mobile de manière à couvrir une large zone (2D ou 3D) à la surface du bassin.

De manière non limitative, les capteurs peuvent en outre consister en des préleveurs et analyseurs de fluide, des préleveurs et analyseurs de carottes ou de tout échantillon prélevé in situ etc.

A partir de ces mesures, on peut notamment estimer la géométrie des unités stratigraphiques du bassin à l'actuel, qualifier les différents dépôts sédimentaires inorganiques (composition minéralogique ou au moins du type de dépôt, épaisseurs, âges, conditions de dépôt etc.), estimer des propriétés pétrophysiques telles que le faciès (lithologie), la porosité, la perméabilité, la saturation en fluides ou encore la teneur en matière organique en des points de mesure du bassin. On peut en outre en déduire les événements géologiques subis par le bassin au cours des temps géologiques (érosion, subsidence, eustatisme etc.). Ces informations déduites des mesures sont toutefois incertaines, car elles résultent de mesures, éventuellement pré-traitées (notamment les mesures sismiques), ou d'une interprétation des mesures (par exemple l'estimation de la géométrie des unités stratigraphiques sur la base des mesures sismiques).

Selon une mise en oeuvre de l'invention, à partir des mesures ainsi réalisées, on peut en outre définir les paramètres d'entrée d'une simulation stratigraphique, tels que la bathymétrie initiale, les apports en sédiments (inorganiques, tels que la production des différents carbonates, et éventuellement organiques), leur transport pour chaque pas de temps. Selon une mise en oeuvre de l'invention, la bathymétrie initiale peut être estimée par une interprétation en environnements de dépôt (fluvial, littoral, marin profond...) des mesures de puits et/ou des mesures sismiques. Selon une mise en oeuvre de l'invention, les coefficients de transport peuvent être définis à partir des environnements sédimentaires modernes (c'est-à-dire observés au temps actuel), en comparant par exemple le flux de sédiment transporté par les fleuves au débit de ces fleuves. Selon une mise en oeuvre de l'invention, les apports de sédiments peuvent être évalués à partir du volume de sédiments déposés dans le bassin.

**2) Détermination d'une distribution spatiale de référence pour au moins un attribut**

Au cours de cette étape, il s'agit de déterminer au moins une distribution spatiale de référence des valeurs d'au moins un attribut représentatif de la stratigraphie du bassin étudié, à partir des mesures de grandeurs physiques réalisées à l'étape 1.

Par attribut représentatif de la stratigraphie du bassin étudié, on entend toute propriété relative à la stratigraphie du bassin, déterminée à partir des mesures de l'étape 1. Par exemple un attribut représentatif de la stratigraphie du bassin étudié peut être le faciès lithologique, l'épaisseur d'une unité stratigraphique, la concentration en sable, la concentration en argile dans une unité stratigraphique, etc.

On appelle distribution spatiale des valeurs d'un attribut, un ensemble de valeurs prises par cet attribut pour différentes positions dans l'espace, et on appelle distribution spatiale de référence des valeurs d'un attribut, une distribution spatiale des valeurs d'un attribut déterminée à partir des mesures de grandeurs physiques réalisées à l'étape 1.

Une distribution spatiale des valeurs d'un attribut peut avoir un support spatial :

- 1D, comme par exemple la distribution du type de faciès lithologique déterminé à partir de mesures diagraphiques pour chaque position spatiale le long d'un puits, le puits pouvant être vertical (dans ce cas, seul Z varie pour une position (X,Y) fixée) ou dévié (dans ce cas, les positions (X,Y,Z) varient).

- 2D, comme par exemple la distribution de la variation de l'épaisseur d'une unité stratigraphique donnée, déterminée par exemple au moyen des mesures sismiques, en différentes positions spatiales (X,Y).

- 3D, comme par exemple la distribution de la composition minéralogique en différentes positions spatiales (X, Y, Z) du bassin étudié, déterminée par exemple au moyen d'une analyse combinée de mesures diagraphiques et sismiques.

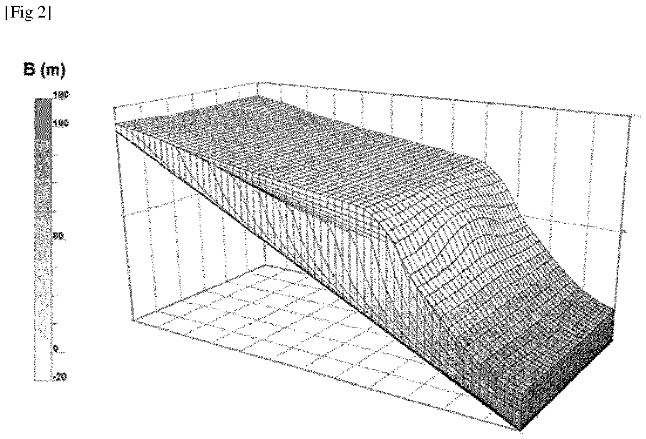

Avantageusement, la détermination d'une distribution spatiale de référence d'un attribut représentatif de la stratigraphie du bassin étudié peut être réalisée à partir d'une représentation maillée représentative dudit bassin (aussi appelée modèle géologique du bassin), déterminée à partir au moins des mesures réalisées à l'étape 1. Une telle représentation maillée est classiquement formée de mailles discrétisant dans l'espace les différentes unités stratigraphiques d'un bassin. La Figure 2 illustre un exemple de représentation maillée d'un bassin sédimentaire en vue tridimensionnelle, chaque maille comprenant une valeur de la bathymétrie B au moment du dépôt.

De manière générale, la construction d'une représentation maillée d'un bassin consiste à discrétiser en trois dimensions l'architecture du bassin et à attribuer des propriétés à chacune des mailles de cette représentation maillée. Pour ce faire, on exploite notamment les mesures des grandeurs physiques réalisées en différents points du bassin telles que décrites ci-dessus, que l'on extrapole et/ou interpole en les différentes mailles de la représentation maillée, suivant des hypothèses plus ou moins restrictives. Selon une mise en oeuvre de l'invention, la représentation maillée du bassin peut être construite au moyen du logiciel OPEN FLOW® (IFP Energies nouvelles, France) ou encore le logiciel GOCAD® (Emerson-Paradigm, USA).

Selon une mise en oeuvre de l'invention, la représentation maillée du bassin étudié comprend notamment en chaque maille, et donc en différentes positions de l'espace, une information sur la teneur en sédiments (sable, argile, carbonates, matière organique...), et les environnements de dépôts (en particulier la bathymétrie au moment du dépôt).

A partir d'une telle représentation maillée, qui permet en quelque sorte de synthétiser l'ensemble des informations (toutefois au moins partiellement incertaines) relatives à la stratigraphie d'un bassin qui peuvent être déduites des mesures réalisées à l'étape 1, on peut aisément extraire au moins une distribution spatiale d'un attribut de référence pour un support spatial donné. Par exemple, on peut facilement déterminer la valeur de l'épaisseur d'une unité stratigraphique donnée pour différentes positions latérales (X,Y) du bassin.

Par la suite, on appelle "modèle stratigraphique de référence" une représentation maillée représentative du bassin déterminée à partir au moins des mesures réalisées à l'étape 1. A noter qu'un tel modèle stratigraphique de référence comporte des incertitudes sur certaines des propriétés qu'il synthétise, au moins pour certaines mailles. En effet, si l'on peut considérer que les mesures de diagraphies sont des données relativement certaines (aux emplacements où elles ont été réalisées), il n'en est pas de même pour les mesures sismiques qui sont classiquement moins précises (résolution moins forte que les données diagraphiques, erreurs engendrées par le prétraitement sismique, unités stratigraphiques parfois difficiles à délimiter en raison de bruits se superposant aux réflexions sismiques, etc).

**3) Détermination d'un modèle stratigraphique simulé par simulation stratigraphique**

Au cours de cette étape, on détermine un modèle stratigraphique simulé à partir d'une simulation stratigraphique exécutée sur ordinateur et de premières valeurs de paramètres d'entrée de la simulation stratigraphique.

Cette étape est répétée au moins deux fois. A la première itération, les valeurs des paramètres d'entrée de la simulation stratigraphique peuvent être déterminées à partir de mesures réalisés sur le bassin tel que décrit à l'étape 1 ci-dessus. Les valeurs des paramètres d'entrée de la simulation stratigraphique sont ensuite modifiées par le procédé selon le premier aspect de l'invention, au moins une fois, par l'application des étapes 4) à 7) décrites ci-dessous.

La mise en oeuvre de cette étape requiert un simulateur stratigraphique. Il s'agit d'un logiciel exécuté sur ordinateur visant à reconstituer les processus sédimentaires ayant affecté le bassin depuis un temps géologique antérieur jusqu'au temps actuel. Ainsi, une simulation stratigraphique numérique est de manière générale implémentée de manière discrète dans le temps, c'est-à-dire qu'une simulation stratigraphique simule l'état stratigraphique du bassin pour une succession de pas de temps. Un pas de temps d'un simulateur stratigraphique correspond à une durée géologique au cours de laquelle des dépôts ou des érosions sédimentaires ont modifié le bassin. Les propriétés (dont la porosité et la minéralogie) de ces dépôts peuvent être relativement hétérogènes au niveau du bassin. La simulation de l'histoire du remplissage d'un bassin sédimentaire est réalisée à partir des paramètres d'entrée représentatifs de l'histoire sédimentaire du bassin étudié. Selon une mise en oeuvre de l'invention, les paramètres d'entrée d'une simulation stratigraphique sont au moins (1) l'espace disponible pour la sédimentation, lié à des mouvements tectoniques et/ou eustatiques et à la compaction mécanique des sédiments (ou tassement des sédiments sous l'effet du poids des couches sus-jacentes) (2) l'apport en sédiments dans le bassin, soit par les frontières, soit par l'intermédiaire d'une production ou d'une précipitation in situ, (3) le transport de ces sédiments (capacité de transport estimée à partir des caractéristiques du sédiment comme la taille des grains ou encore leur densité, du flux d'eau s'écoulant à la surface du sol et de la pente locale du bassin) dans l'espace disponible créé. Le système d'équations décrivant ces processus peut par exemple être résolu par une discrétisation spatiale en volumes finis, et un schéma explicite en volumes finis. Selon une mise en oeuvre de l'invention, le résultat d'une simulation stratigraphique pour un pas de temps correspond à une représentation maillée pour laquelle chaque maille est au moins remplie par les informations suivantes : la teneur en sédiments (sable, argile, carbonates, matière organique...), et les environnements de dépôts (en particulier la bathymétrie au moment du dépôt). De manière très classique, la représentation maillée issue d'une simulation stratigraphique est aussi renseignée avec des propriétés caractéristiques de l'environnement de dépôt (profondeur de l'eau, élévation du bassin, ...). On peut trouver une description d'un tel simulateur stratigraphique dans le document (Granjeon et Joseph, 1999). Un exemple d'un tel simulateur stratigraphique est le logiciel DIONISOS FLOW® (IFP Energies nouvelles, France).

Par la suite, on appelle "modèle stratigraphique simulé" une représentation maillée représentative du bassin déterminée par une simulation stratigraphique et des valeurs des paramètres d'entrée de la simulation stratigraphique.

**4) Détermination d'au moins une distribution spatiale simulée pour chacun des attributs**

Au cours de cette étape, pour chaque distribution spatiale de référence des valeurs d'un attribut déterminé tel que décrit à l'étape 2, on détermine une distribution spatiale, dite simulée, pour ce même attribut que la distribution spatiale de référence, à partir de la représentation maillée issue de la simulation stratigraphique tel que déterminée à l'étape précédente. Cette étape est immédiate puisque la représentation maillée issue de la simulation contient des valeurs de propriétés en chaque maille : on peut donc facilement déterminer la valeur d'un attribut, tel que l'épaisseur d'une unité stratigraphique donnée, pour différentes positions latérales (X,Y) du bassin.

Selon une mise en oeuvre de l'invention, dans le cas où le support spatial de la distribution de référence diffère du support spatial de la distribution simulée, on applique un ré-échantillonnage du support spatial de la distribution de référence et/ou un ré-échantillonnage du support spatial de la distribution simulée de manière à se ramener à un support spatial identique.

Selon une mise en oeuvre de l'invention, dans le cas où le support spatial de la distribution de référence diffère du support spatial de la distribution simulée dans la direction X et/ou Y (ce qui peut se produire par exemple dans le cas d'un maillage plus grossier utilisé pour la simulation stratigraphique, dont est issue la distribution simulée, que celui utilisé pour construire la distribution de référence), on peut utiliser des méthodes classiques de mise à l'échelle, dites de "downscaling" ou d'"upscaling", bien connues dans le domaine. Par exemple, dans le cas d'un passage à des mailles plus grossières, on peut associer à une maille grossière le faciès le plus présent dans les mailles fines recoupant la maille grossière, ou encore utiliser des moyennes pour les propriétés continues.

Selon une mise en oeuvre de l'invention, dans le cas où le support spatial de la distribution de référence diffère du support spatial de la distribution simulée dans la direction Z (ce qui peut se produire par exemple lorsque les épaisseurs de sédiments simulées sont différentes des épaisseurs de sédiments observées), on peut dans un premier temps effectuer un raccourcissement/étirement dans la direction Z de la distribution simulée et/ou de la distribution de référence pour se ramener à une même épaisseur dans une ou plusieurs unités stratigraphiques. Avantageusement, comme cela sera décrit en section 7, un terme d'erreur spécifique peut être ajouté à la fonction objectif pour tenir compte des erreurs engendrées par cette transformation d'au moins un support spatial. Puis, dans un second temps, on peut procéder à un ré-échantillonnage du support spatial de la distribution de référence et/ou un ré-échantillonnage du support spatial de la distribution simulée de manière à se ramener à un support spatial identique. Avantageusement, on peut procéder au ré-échantillonnage à la fois du support spatial de la distribution de référence et du support spatial de la distribution simulée pour se ramener à une grille dans la direction Z régulière.

Selon une mise en oeuvre de l'invention, dans le cas où le support spatial de la distribution de référence diffère du support spatial de la distribution simulée dans la direction Z, et que la distribution est de type 1D, on peut réaliser les étapes suivantes :

a) on étire ou on raccourcit verticalement la distribution simulée afin que son épaisseur totale soit égale à celle de la distribution de référence. La distribution simulée après transformation est donc définie par :

$$F^{s,n} = (f_j^s)_{j=1..n2}$$

et

$$T^{s,n} = (t_j^{s,n})_{j=1..n2}$$

avec

- $t_j^{s,n} = t_j^s \times TT^m/TT^s$

- $F^m = (f_j^m)_{j=1..n1}$ et $T^m = (t_j^m)_{j=1..n1}$ : la succession des n1 valeurs de référence de l'attribut et l'épaisseur associée

- $F^s = (f_j^s)_{j=1..n2}$ et $T^s = (t_j^s)_{j=1..n2}$ : la succession des n2 valeurs simulées de l'attribut et l'épaisseur associée

- $TT^m = \sum_{j=1}^{n1} t_j^m$ l'épaisseur totale de la succession des n1 valeurs de référence de l'attribut que l'on cherche à reproduire

- $TT^s = \sum_{j=1}^{n2} t_j^s$ l'épaisseur totale la succession des n2 valeurs simulées de l'attribut correspondant.

b) on ré-échantillonne la succession des valeurs simulées $F^{s,n}$ et la succession des valeurs de référence $F^m$ : selon une mise en oeuvre de l'invention, on définit une grille régulière sur l'intervalle [0, $TT^m$] de N mailles de taille $\Delta z$, en considérant une discrétisation fine par rapport aux différentes épaisseurs des unités stratigraphiques, et on plaque la succession des valeurs simulées/de référence de l'attribut sur cette grille. Pour cela, on associe dans chaque maille fine régulière la valeur de l'attribut dans la couche qui recouvre le plus la maille fine. Avantageusement, le pas de discrétisation $\Delta z$ peut être choisi suffisamment petit pour ne pas introduire d'erreur trop grande lors de la mise à l'échelle.

c) optionnellement, on peut déterminer un terme d'erreur, noté $E_{TR}$, lié à cette mise à l'échelle, sous la forme de la différence entre les épaisseurs totales de chaque séquence au carré, soit :

$$E_{TR} = (TT^m - TT^s)^2$$

L'utilisation de ce terme d'erreur sera explicitée à l'étape 7 ci-dessous.

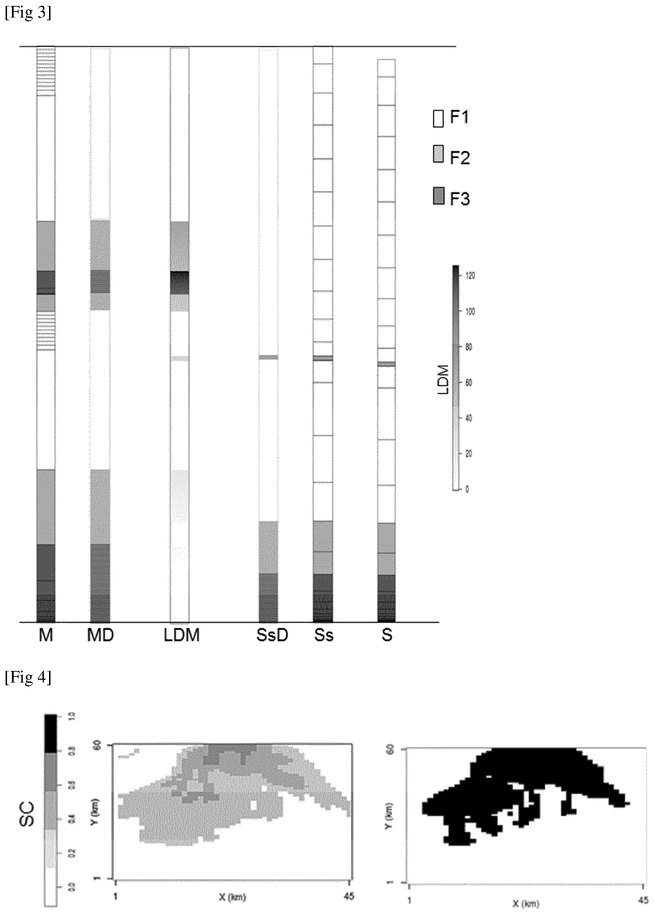

Ces étapes de ré-échantillonnage sont illustrées sur la figure 3 pour des distributions spatiales d'un attribut de type faciès sédimentaire dans un puits vertical. Sur cette figure, on peut observer une colonne M (respectivement S) correspondant à la succession dans la direction Z de valeurs de référence (respectivement simulées) de faciès, variant entre les valeurs F1, F2, et F3. On peut observer sur cette figure que les deux colonnes M et S n'ont pas la même longueur. Dans un premier temps et selon l'étape a), la colonne M est étirée pour aboutir à une colonne Ss de même longueur que la colonne de référence M. Puis, selon l'étape b) décrite ci-dessus, les deux colonnes M et Ss sont ré-échantillonnées pour produire des colonnes, notées respectivement MD et SsD, échantillonnées de manière régulière et identique. Ces deux colonnes sont donc maintenant comparables directement. La colonne LDM sera décrite ultérieurement.

Selon une mise en oeuvre de l'invention, dans le cas où le support spatial de la distribution de référence diffère du support spatial de la distribution simulée dans la direction Z, et que la distribution est de type 2D ou 3D, on applique les étapes a) et b) décrites ci-dessus pour une distribution 1D à chaque colonne constituant la distribution 2D ou 3D. Puis de manière optionnelle, on peut déterminer un terme d'erreur, noté $E_{TR}$, lié à cette mise à l'échelle sous la forme de la somme sur chaque colonne des différences au carré entre les épaisseurs totales de référence et simulées.

**5) Détermination d'une image classifiée pour chaque distribution spatiale simulée et chaque distribution spatiale de référence**

Au cours de cette étape, lorsqu'appliquée une première fois, il s'agit de déterminer une image classifiée :

- pour chacune des distributions spatiales de référence des valeurs relatives à au moins un attribut représentatif de la stratigraphie du bassin déterminées à l'étape 2, optionnellement ré-échantillonnées tel que décrit à l'étape précédente ;

- pour chacune des distributions spatiales simulées des valeurs relatives à au moins un attribut représentatif de la stratigraphie du bassin déterminées à l'étape 3, optionnellement ré-échantillonnées tel que décrit à l'étape précédente.

Au cours de cette étape, lorsqu'appliquée une nouvelle fois par réitération des étapes 3 à 7 selon la variante principale du procédé selon le premier aspect de l'invention, il s'agit de déterminer une image classifiée pour chacune des distributions spatiales simulées des valeurs relatives à au moins un attribut représentatif de la stratigraphie du bassin mises à jour par au moins une réitération des étapes 3 à 7.

Selon l'invention, on utilise une méthode de classification (ou encore une méthode de partitionnement de données) pour transformer une distribution spatiale des valeurs d'un attribut en une image classifiée. Cette classification revient à séparer les valeurs de l'attribut considéré en K classes correspondant à des intervalles de valeur distincts, déterminés automatiquement par une méthode de classification. Selon l'invention, l'image classifiée comprend au moins deux classes (autrement dit K=2). Ainsi, selon l'invention on détermine une image classifiée d'une distribution spatiale des valeurs d'un attribut, au moyen d'une méthode de classification, pour regrouper les valeurs de cet attribut dans cette distribution en au moins deux classes.

Cette transformation peut être vue comme une transformation de la distribution spatiale (par exemple de référence) en une image en niveaux de gris, ce qui permet de simplifier l'information que l'on cherche à reproduire, en délimitant des zones dans lesquelles les valeurs de l'attribut considéré ont des tendances similaires. Par exemple, la figure 4 à gauche illustre la distribution spatiale de la concentration en sable SC moyennée sur chacune des colonnes d'une représentation maillée représentative d'un bassin, et la figure 4 à droite illustre une image classifiée en deux classes de cette distribution spatiale, la couleur noire représentant les positions spatiales de la distribution de référence pour lesquelles la concentration en sable est supérieure à 20% et la couleur blanche représentant les autre zones.

Selon une mise en oeuvre de l'invention, la méthode de classification utilisée peut être la méthode K-means (telle que décrite par exemple dans le document (McKay, 2003)), la méthode du partitionnement spectral (telle que décrite par exemple dans le document (Ng et al., 2002)), la méthode des cartes auto-organisatrices (telle que décrite par exemple dans le document (Kohonen 2001)), ou encore la méthode par regroupement hiérarchique (telle que décrite par exemple dans le document (Grus, 2016)). De telles méthodes sont en particulier appropriées dans le cas d'un attribut dont les valeurs varient de manière continue (par opposition à discrète).

Selon une mise en oeuvre de l'invention selon laquelle au moins un attribut considéré varie en prenant des valeurs discrètes ou encore catégorielles (cas d'un attribut correspondant par exemple à un lithofaciès), on peut attribuer une classe à chaque valeur de cet attribut. C'est le cas par exemple pour les distributions spatiales de faciès lithologique de la figure 3 discutée ci-dessus, pour lesquelles les colonnes MD et SsD peuvent être considérées comme des images classifiées. Selon une mise en oeuvre de l'invention, on peut également regrouper plusieurs valeurs d'un tel attribut dans une seule classe (par exemple, on peut regrouper dans une même classe les valeurs des faciès lithologiques connus pour avoir des perméabilités très faibles). Un ré-ordonnancement des classes peut également être envisagé. Par exemple, on peut associer la valeur 0 à la classe de l'attribut occupant la plus grande surface sur la carte de la distribution spatiale de référence. L'image à reproduire peut alors être la distribution des autres classes dans le domaine, que l'on peut renuméroter par exemple par ordre décroissant de surface occupée sur la carte de référence.

**6) Détermination d'une distribution de dissimilarités locales entre images classifiées de référence et simulées**

Au cours de cette étape, il s'agit de déterminer une distribution des dissimilarités locales entre chacun des couples formés par une image classifiée de référence et son image classifiée simulée correspondante.

Par la suite, les images classifiées de référence et simulées déterminées à l'étape précédente sont respectivement notées $I^m = (I_j^m)_{j=1..N}$ et $I^s = (I_j^s)_{j=1..N}$. Elles correspondent à des images binaires (lorsque le nombre de classes K vaut 2) ou à des images en niveau de gris (pour $K > 2$).

Selon une mise en oeuvre de l'invention, on détermine une distribution des dissimilarités locales entre une image classifiée de référence et son image classifiée simulée correspondante en appliquant au moins les étapes suivantes :

i) On détermine une transformée en distance, notée DT par la suite, pour chacune de ces deux images.

Selon une mise en oeuvre de l'invention selon laquelle l'image considérée est une image binaire, la transformée en distance peut être définie, pour chaque pixel y de l'image, par la distance minimale entre ce pixel et la zone de l'image que l'on cherche à reproduire. Selon une mise en oeuvre selon laquelle on a attribué une valeur non nulle aux zones d'intérêt, la transformée en distance peut s'écrire

$$DT(I)_j = min_{i,\text{ tel que } I_i=1}(d(i,j)) \text{ pour tout } j = 1 \dots N,$$

avec

$d(i,j)$ représentant la distance entre les pixels $i$ et $j$.

Selon une mise en oeuvre de l'invention selon laquelle l'image considérée est formée de plus de deux classes (image dite en niveaux de gris), on peut appliquer l'extension de la transformée en distance aux images en niveaux de gris proposée par Molchanov et Teran (2003). Cette approche consiste à transformer l'image en niveaux de gris I en un ensemble d'images binaires $I^1, ..., I^{K-1}$ définies par :

$$I_j^k = \begin{cases} 1 \text{ si } I_j \geq k \\ 0 \text{ sinon} \end{cases} \text{ pour tout } j = 1 \dots N$$

La transformée en distance de l'image en niveaux de gris est alors définie comme la somme (éventuellement pondérée) des transformées en distance des images binaires $I^1, \dots, I^{K-1}$. Alternativement, on peut décomposer les images en niveaux de gris simulée et de référence en plusieurs images binaires dont chacune contient la localisation d'une seule classe. On calcule alors la transformée en distance de chaque image binaire obtenue.

ii) On détermine la distribution des dissimilarités locales, notée LDM par la suite, entre

les deux images classifiées $I^m$ et $I^s$ à l'aide d'une mesure locale de la distance de Hausdorff, par exemple selon la méthode décrite dans le document (Baudrier *et al.*, 2008). Plus précisément, pour chaque pixel $j = 1..N$, on détermine la distribution des dissimilarités locales LDM entre les deux images classifiées $I^m$ et $I^s$ selon une formule du type :

$$LDM_j = |I_j^m - I_j^s| \times \max\left(DT(I^m)_j, DT(I^s)_j\right)$$

Le premier terme de la formulation pondère la transformée en distance par la différence entre les classes de référence et simulées dans le pixel j. La dissimilarité locale à ce pixel est donc nulle s'il correspond à la même classe dans les deux distributions $I^m$ et $I^s$. Selon une mise en oeuvre de l'invention selon laquelle, à l'étape i) ci-dessus, on calcule une transformée en distance par classe, on peut par exemple calculer la carte des dissimilarités locales pour chaque classe selon la formule précédente, puis sommer les différentes cartes de dissimilarités obtenues.

A titre d'illustration, la colonne LDM de la figure 3 présente la distribution des dissimilarités locales entre les images classifiées MD et SsD présentées également en Figure 3. On peut observer que ces dissimilarités locales sont nulles dans les zones où les faciès sont identiques pour les données (M) et la simulation (S). Dans les autres zones, leur valeur dépend de la transformée en distance des images classifiées et de l'écart entre les classes.

**7) Mise à jour du modèle stratigraphique**

Au cours de cette étape, il s'agit de mettre à jour le modèle stratigraphique déterminé à l'étape 3, au moins à partir de chacune des distributions des dissimilarités locales déterminées tel que décrit ci-dessus.

Selon l'invention, on met à jour le modèle stratigraphique déterminé à l'étape 3 de la manière suivante :

- on modifie au moins un des paramètres de la simulation stratigraphique à partir desquels a été obtenu le modèle stratigraphique de l'étape 3, pour identifier un nouveau modèle stratigraphique minimisant une fonction objectif formée à partir de chacune des distributions des dissimilarités locales déterminées à l'étape précédente ;
- puis on lance une nouvelle simulation stratigraphique en utilisant les paramètres de simulation ainsi modifiés.

Selon une mise en oeuvre de l'invention, la fonction objectif à minimiser peut s'écrire comme la somme pondérée des dissimilarités locales LDM au carré entre les images classifiées de référence et simulée tel que décrit ci-dessus, comme par exemple selon une formule du type :

$$OF = \sum_{j=1}^{N} (LDM_j)^2.$$

Selon une mise en oeuvre de l'invention, la fonction objectif à minimiser peut s'écrire comme la somme pondérée des dissimilarités locales au carré entre une image classifiée de référence et une image classifiée simulée et d'un terme d'erreur lié à la mise à l'échelle optionnellement déterminé à l'étape 4, soit selon une formule du type :

$$OF = w_{TR}E_{TR} + w_F \sum_{j=1}^{N} (LDM_j)^2$$

où $w_{TR}$ et $w_F$ sont des poids prédéfinis de manière à donner un poids relatif plus important, lors de la minimisation de la fonction coût, au terme de dissimilarité locale ou au terme d'erreur lié à la mise à l'échelle. Ces poids peuvent par exemple être liés à l'erreur sur les mesures et/ou à la confiance que l'on a dans l'interprétation de ces mesures.

Selon une mise en oeuvre de l'invention, on utilise un algorithme d'optimisation pour minimiser la fonction objectif telle que décrite ci-dessus, définie comme la somme pondérée des erreurs pour chacune des distributions. Il peut s'agir par exemple d'un algorithme de minimisation local, comme la méthode de type quasi Newton décrite par exemple dans le document (Sinoquet et al, 2008), ou d'un algorithme de minimisation global comme la méthode EGO (Efficient Global Optimization) décrite par exemple dans le document (Jones et al., 1998).

Selon l'invention, à la fin de l'étape 7, on obtient des valeurs des paramètres de simulation mis à jour, et on répète au moins l'étape 3 décrite ci-dessus (étape de simulation stratigraphique) en utilisant ces valeurs des paramètres de simulation modifiés. On détermine ainsi un modèle stratigraphique simulé modifié, ou autrement dit mis à jour.

Selon une mise en oeuvre de l'invention, on obtient des valeurs des paramètres de simulation mis à jour, et on répète (ou autrement dit on réitère) la séquence des étapes 3 à 7 décrites ci-dessus, en utilisant à chaque ré-itération les valeurs de paramètres de simulation déterminés à la fin de l'étape 7 de l'itération précédente. On arrête ce processus itératif lorsque la fonction objectif déterminée à l'étape 7 de l'itération courante satisfait à au moins un critère prédéfini. Selon une mise en oeuvre de l'invention, ce critère peut être par exemple une valeur maximale acceptable de la fonction objectif, un pourcentage de décroissance de la fonction coût mesurée entre sa valeur à la première itération et sa valeur à l'itération en cours, un nombre d'itérations maximal souhaitable (pour limiter les temps de calcul).

## 8) Exploitation des hydrocarbures du bassin

Cette étape est à mettre en oeuvre, à l'issue des étapes précédentes, dans le cas du procédé selon le deuxième aspect de l'invention, qui consiste en un procédé d'exploitation des hydrocarbures d'un bassin sédimentaire.

A l'issue de la mise en oeuvre des précédentes étapes, on dispose d'un modèle stratigraphique mis à jour de manière à être en accord avec les mesures réalisées sur le bassin. Un tel modèle stratigraphique d'un bassin contient de nombreuses informations pertinentes pour évaluer le potentiel pétrolier d'un bassin et ainsi optimiser son exploitation.

De manière implicite, et comme cela est classique en simulation stratigraphique, on dispose à l'issue de l'étape précédente d'informations relatives par exemple et de manière non limitative à la teneur en sable, la teneur en argile, l'épaisseur, ou encore le type de faciès des unités stratigraphiques du bassin étudié. Par exemple, la teneur en sable est une information importante pour l'exploitation du bassin car une unité stratigraphique ayant une forte teneur en sable peut constituer une roche réservoir de bonne qualité. Et si une couche ayant une forte teneur en argile surplombe cette couche à forte teneur en sable, alors il est possible que l'on soit en présence d'un piège pétrolier. Le volume des informations à analyser étant très important, et le lien entre ces différentes informations étant complexe, il est bien évident que l'ensemble des informations contenues dans un modèle stratigraphique sont analysées de manière automatisée, comme cela est décrit ci-après.

Selon l'invention, à partir de telles informations, on détermine au moins un schéma d'exploitation des hydrocarbures contenus dans le bassin sédimentaire étudié. De manière générale, un schéma d'exploitation comprend un nombre, une géométrie et une implantation (position et espacement) des puits injecteurs et producteurs à forer dans le bassin. Un schéma d'exploitation peut en outre comprendre un type de récupération assistée des hydrocarbures contenus dans le ou les réservoirs du bassin, telle qu'une récupération assistée au moyen de l'injection d'une solution comprenant un ou des polymères, de la mousse de $CO_2$, etc. Un schéma d'exploitation d'un réservoir d'hydrocarbures d'un bassin doit par exemple permettre un fort taux de récupération des hydrocarbures piégés dans ce réservoir, sur une longue durée d'exploitation, et nécessitant un nombre de puits limité. Autrement dit, le spécialiste prédéfinit des critères d'évaluation selon lesquels un schéma d'exploitation des hydrocarbures d'un bassin sédimentaire est considéré comme suffisamment performant pour être mis en oeuvre.

Selon un mode de mise en oeuvre de l'invention, on définit une pluralité de schémas d'exploitation des hydrocarbures contenus dans un ou des réservoirs géologiques du bassin étudié et on estime, à l'aide d'un simulateur de réservoir (tel que le logiciel PUMA FLOW® (IFP Energies nouvelles, France)), au moins un critère d'évaluation de ces schémas d'exploitation. Ces critères d'évaluation peuvent comprendre la quantité d'hydrocarbures produits pour chacun des différents schémas d'exploitation, la courbe représentative de l'évolution de la production dans le temps au niveau de chacun des puits envisagés, le rapport huile sur gaz (GOR) au niveau de chaque puits envisagé etc. Le schéma selon lequel les hydrocarbures contenus dans le ou les réservoirs du bassin étudié sont réellement exploités peut alors correspondre à celui satisfaisant au moins un des critères d'évaluation des différents schémas d'exploitation. A noter que la définition de la pluralité de schémas d'exploitation à tester peut être elle-même déterminée de manière automatisée, par exemple au moyen du logiciel COUGAR® (IFP Energies nouvelles, France).

Puis, une fois un schéma d'exploitation déterminé, les hydrocarbures piégés dans le ou les réservoirs pétroliers du bassin sédimentaire étudié sont exploités en fonction de ce schéma d'exploitation, notamment au moins en forant les puits injecteurs et producteurs du schéma d'exploitation ainsi déterminés, et en installant les infrastructures de production nécessaires au développement de ce ou ces réservoirs. Dans le cas où le schéma d'exploitation a en outre été déterminé en estimant la production d'un réservoir associée à différents types de récupération assistée, on injecte dans le puits injecteur le ou les types d'additifs (polymères, tensio-actifs, mousse de $CO_2$) sélectionnés.

Il est bien entendu qu'un schéma d'exploitation des hydrocarbures d'un bassin peut être évolutif sur la durée de l'exploitation des hydrocarbures de ce bassin, en fonction par exemple de connaissances additionnelles relatives au bassin acquises pendant cette exploitation, des améliorations dans les différents domaines techniques intervenant lors d'une exploitation d'un gisement d'hydrocarbures (améliorations dans le domaine du forage, de la récupération assistée par exemple).

**Equipement et produit programme d'ordinateur**

Le procédé selon l'invention est mis en oeuvre au moyen d'un équipement (par exemple un poste de travail informatique) comprenant des moyens de traitement des données (un processeur) et des moyens de stockage de données (une mémoire, en particulier un disque dur), ainsi qu'une interface d'entrée et de sortie pour saisir des données et restituer les résultats du procédé.

Les moyens de traitement de données sont configurés pour réaliser en particulier les étapes 2 à 7 décrites ci-dessus.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé tel que décrit précédemment, lorsque ledit programme est exécuté sur un ordinateur.

**Exemples**

Les avantages du procédé et du système selon l'invention sont présentés ci-après dans deux exemples d'application comparatifs.

**Exemple 1**

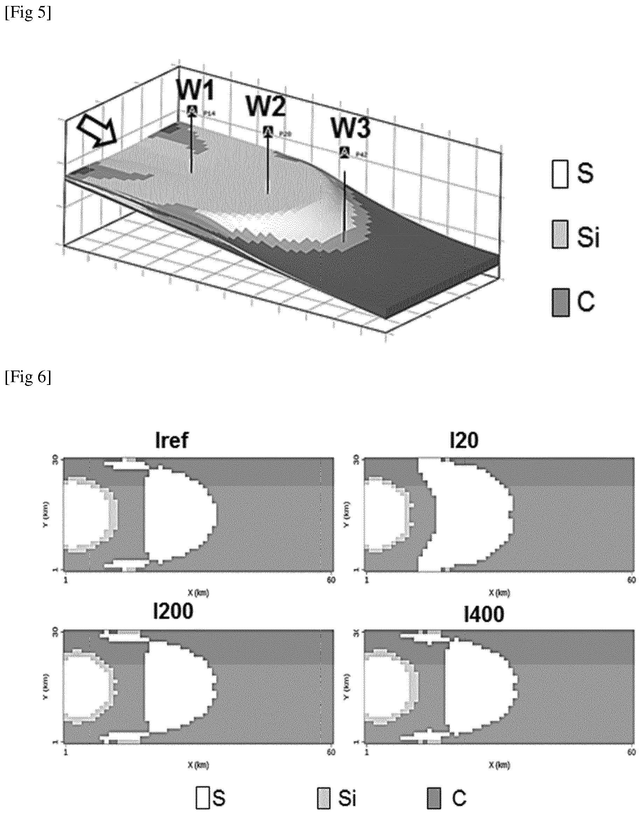

Le premier exemple d'application concerne la modélisation sédimentaire d'un bassin formé par la progradation d'un delta. La figure 5 présente une représentation du bassin construite à partir de mesures sismiques et de mesures diagraphiques réalisées dans les trois puits W1, W2, W3. L'analyse des mesures réalisées sur le bassin permet en outre de déterminer que l'apport de sédiments dans ce bassin se fait via une source, dont l'emplacement et la direction sont représentés par une flèche. Les sédiments apportés par cette source sont composés de sable S et d'argile C, et le modèle stratigraphique de référence, construit à partir des mesures, est formé de grès S, de siltite Si et d'argile C.

Par la mise en oeuvre du procédé selon le premier aspect de l'invention, on cherche à reproduire la distribution du faciès le plus probable dans chaque colonne de la représentation de la figure 5, ainsi que la succession des faciès observés aux trois puits verticaux W1, W2 et W3. Le faciès étant une propriété discrète, on réalise une classification en attribuant une valeur numérique à chaque type de faciès. Sept paramètres d'entrée de la simulation stratigraphique sont considérés comme incertains, et sont donc à mettre au jour en tenant compte des mesures réalisées sur le bassin. Ces paramètres incertains décrivent les variations du niveau de la mer au cours du temps, la quantité de sédiments apportés dans le bassin et la capacité de ces sédiments à y être transportés. La minimisation de la fonction objectif est réalisée au moyen de l'algorithme d'optimisation EGO basé sur des surfaces de réponses, tel que décrit dans le document (Jones et al., 1998). Les paramètres de la simulation stratigraphique sont alors modifiés jusqu'à obtenir un modèle stratigraphique qui tiennent compte des mesures réalisées sur le bassin.

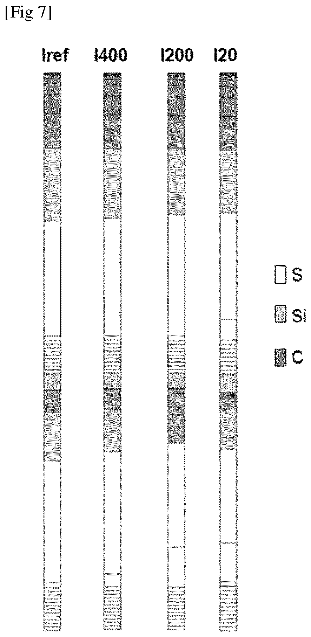

Les figures 6 et 7 présentent respectivement l'évolution de la distribution spatiale moyenne par colonne du faciès le plus probable et de la séquence sédimentaire le long du puits W2, au bout de 20 itérations (Iter20), de 200 itérations (Iter200) et de 400 itérations (Iter400), par rapport à une image classifiée de référence (Iref). On peut observer sur ces figures que le procédé selon le premier aspect de l'invention permet de déterminer un modèle stratigraphique pour lequel les valeurs simulées sont très proches des mesures réalisées sur le bassin.

**Exemple 2**

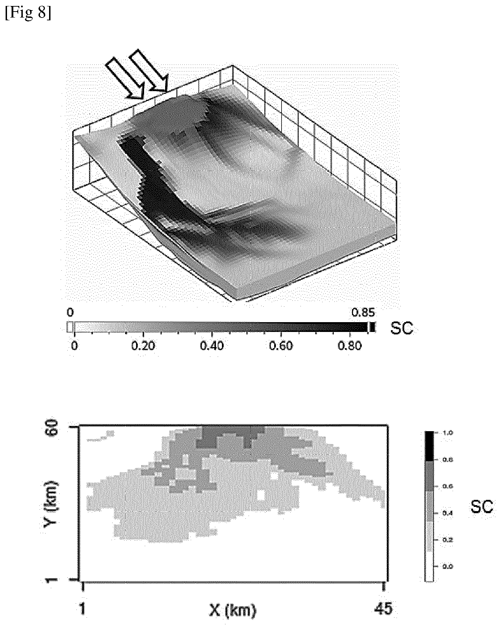

Le deuxième exemple d'application concerne la modélisation sédimentaire d'un bassin formé par un système turbiditique. La figure 8 en haut présente une représentation du bassin construite à partir de mesures sismiques et de mesures diagraphiques. Plus précisément, la figure 8 en haut présente la distribution de la proportion de sable SC dans le bassin. L'analyse des mesures réalisées sur le bassin permet en outre de déterminer que l'apport de sédiments dans ce bassin se fait via deux sources, dont l'emplacement et la direction sont représentés par deux flèches sur la figure 8 en haut. Les sédiments apportés par ces deux sources sont composés de sable et d'argile.

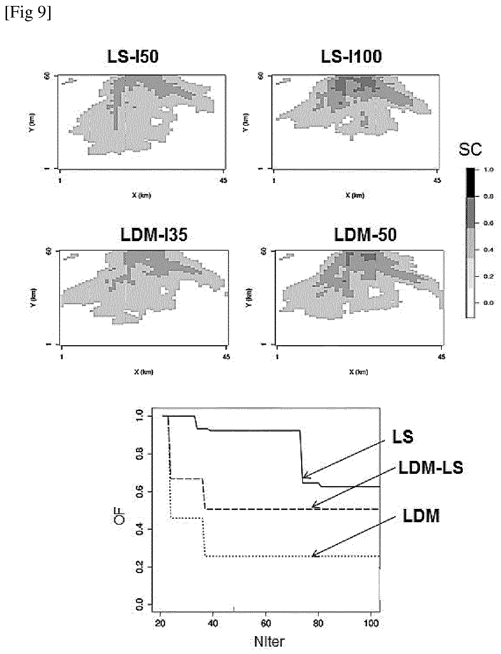

Par la mise en oeuvre du procédé selon le premier aspect de l'invention, on cherche à reproduire la distribution moyenne en sable SC dans chaque colonne du modèle de référence, qui est représentée dans la figure 8 en bas. Quatre paramètres d'entrée de la simulation stratigraphique sont considérés comme incertains, et sont donc à mettre au jour en tenant compte des mesures réalisées sur le bassin. Ces paramètres incertains décrivent la quantité de sédiments dans le bassin et la capacité de ces sédiments à être transportés en milieu marin. La figure 9 présente la distribution moyenne en sable dans chaque colonne déterminée au moyen d'un procédé selon l'art antérieur (voir les deux figures 9 en haut) basé sur une comparaison maille à maille des données et valeurs simulées, respectivement au bout de 50 itérations (LS-I50) et au bout de 100 itérations (LS-I100), et par une mise en oeuvre du procédé selon le premier aspect de l'invention (voir les deux figures 9 au milieu), respectivement au bout de 35 itérations (LDM-I35) et au bout de 50 itérations (LS-I50). Par ailleurs, la figure 9 en bas présente l'évolution de la fonction objectif normalisée OF pour le meilleur modèle courant en fonction du nombre d'itérations Niter, pour le procédé selon l'art antérieur (courbe LS) et pour le procédé selon le premier aspect de l'invention (courbe LDM). La courbe LDM-LS a été réalisée a posteriori, et représente l'évolution de la somme des erreurs maille à maille pour le meilleur modèle courant obtenu au cours des itérations par le procédé selon le premier aspect de l'invention ; une telle courbe peut donc être directement comparée à la courbe LS de la fonction objectif obtenue par le procédé selon l'art antérieur. Les deux optimisations ont été réalisées avec l'algorithme EGO tel que décrit dans le document (Jones et al., 1998). On peut observer que le procédé selon le premier aspect de l'invention, basé sur une mesure des dissimilarités locales, permet de minimiser plus rapidement la fonction objectif par rapport à sa valeur initiale pour un même nombre total de simulations. De plus, le meilleur modèle obtenu au cours de ces itérations présente une erreur inférieure à celle obtenue par un procédé selon l'art antérieur. Cela peut probablement s'expliquer par le fait que la méthode selon l'invention se concentre sur les zones d'intérêt et non sur les données dans chaque maille, ce qui peut en quelque sorte simplifier le problème à résoudre en relâchant la contrainte de calage.

Ainsi le procédé selon le premier aspect de l'invention permet de mettre à jour un modèle stratigraphique d'un bassin sédimentaire en fonction de mesures réalisées in situ, et en particulier de retrouver les grandes tendances des variations spatiales des propriétés du bassin que l'on cherche à reproduire. Un tel modèle peut alors servir de modèle initial pour lancer une nouvelle mise à jour du modèle stratigraphique, via une fonction objectif qui serait basée sur une comparaison maille à maille tel que selon l'art antérieur. En effet, une fois les grandes tendances spatiales retrouvées, une comparaison maille à maille pourrait s'avérer pertinente, notamment dans le cas de propriétés continues, afin de reproduire plus en détails la répartition des valeurs de ces propriétés dans les zones déjà identifiées par le procédé selon le premier aspect de l'invention.

En outre, le procédé selon le premier aspect de l'invention permet de traiter de façon simultanée la géométrie des couches du bassin et les propriétés des sédiments dans ces couches.

Par ailleurs, le procédé selon le deuxième aspect de l'invention offre une meilleure connaissance du bassin étudié, en termes d'informations permettant de définir un schéma d'exploitation des hydrocarbures de ce bassin satisfaisant à des critères prédéfinis, ce qui contribue à améliorer l'exploitation des hydrocarbures du bassin étudié.

## Revendications

1. Procédé mis en oeuvre par ordinateur pour mettre à jour un modèle stratigraphique d'un bassin sédimentaire en fonction de mesures réalisées sur ledit bassin, au moyen d'une simulation stratigraphique exécutée sur ordinateur et à partir de valeurs de paramètres de ladite simulation stratigraphique, ladite simulation stratigraphique visant à reconstituer des processus sédimentaires ayant affecté le bassin depuis un temps géologique antérieur jusqu'au temps actuel, lesdits paramètres de ladite simulation stratigraphique comprenant un espace disponible pour la sédimentation, lié à des mouvements tectoniques et/ou eustatiques et à la compaction mécanique des sédiments, un apport en sédiments dans ledit bassin, soit par les frontières, soit par l'intermédiaire d'une production ou d'une précipitation in situ, et un transport desdits sédiments dans ledit espace disponible, **caractérisé en ce qu'**on applique au moins les étapes suivantes :

   A) On réalise des mesures de grandeurs physiques relatives audit bassin au moyen de capteurs, lesdites mesures comprenant au moins des mesures diagraphiques et des mesures sismiques ;
   B) A partir desdites mesures, on détermine au moins une première distribution spatiale de valeurs d'un attribut représentatif de ladite stratigraphie dudit bassin, et on détermine une première image classifiée relative à ladite première distribution spatiale au moyen d'une méthode de classification pour regrouper lesdites valeurs dudit attribut de ladite première distribution spatiale en au moins deux classes ;
   C) Au moyen de ladite simulation stratigraphique exécutée avec lesdites valeurs desdits paramètres de ladite simulation, on détermine un modèle stratigraphique ;
   D) On en déduit au moins une deuxième distribution spatiale de valeurs dudit attribut représentatif de ladite stratigraphie dudit bassin, et on détermine une deuxième image classifiée relative à ladite deuxième distribution spatiale au moyen de ladite méthode de classification pour regrouper lesdites valeurs dudit attribut de ladite deuxième distribution spatiale selon lesdites au moins deux classes de ladite première image classifiée ;

E) On détermine une distribution de dissimilarités locales entre lesdites première et deuxième images classifiées, et on modifie une valeur d'au moins un desdits paramètres de ladite simulation stratigraphique de façon à minimiser une fonction objectif formée à partir d'au moins ladite distribution desdites dissimilarités locales ;

F) On met à jour ledit modèle stratigraphique en répétant au moins l'étape C) avec lesdites valeurs desdits paramètres de simulation modifiées.

2. Procédé selon la revendication 1, dans lequel on met à jour ledit modèle stratigraphique à l'étape F) en répétant la séquence des étapes C), D) et E) jusqu'à ce que ladite fonction objectif satisfasse au moins un critère prédéfini.

3. Procédé selon l'une des revendications précédentes, dans lequel ladite deuxième distribution spatiale desdites valeurs dudit attribut est définie sur un support spatial différent du support spatial de ladite première distribution spatiale desdites valeurs dudit attribut, et dans lequel on rééchantillonne au moins ladite deuxième distribution spatiale desdites valeurs dudit attribut de manière à ce que lesdites première et deuxième distributions spatiales desdites valeurs dudit attribut soient définies sur un support spatial identique.

4. Procédé selon l'une des revendications précédentes, dans lequel ladite fonction objectif est formée à partir au moins d'une somme pondérée desdites dissimilarités locales au carré observées en chacun des pixels desdites première et deuxième images classifiées,

5. Procédé selon les revendications 3 et 4 en combinaison, dans lequel ladite fonction objectif comprend en outre un terme d'erreur lié audit rééchantillonnage d'au moins ladite deuxième distribution spatiale desdites valeurs dudit attribut

6. Procédé selon l'une des revendications précédentes, dans lequel ledit attribut représentatif de ladite stratigraphie est choisi parmi le faciès lithologique, l'épaisseur d'une unité stratigraphique, la concentration moyenne en sable dans une unité stratigraphique, la concentration moyenne en argile dans une unité stratigraphique.

7. Procédé selon l'une des revendications précédentes, dans lequel ladite méthode de classification est choisie parmi : la méthode K-means, la méthode du partitionnement spectral, la méthode des cartes auto-organisatrices, ou encore la méthode par regroupement hiérarchique.

8. Procédé selon l'une des revendications précédentes, dans lequel on utilise la distance de Hausdorff pour déterminer la distribution des dissimilarités locales,

9. Produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé selon l'une des revendications précédentes, lorsque ledit programme est exécuté sur un ordinateur.

10. Procédé pour exploiter des hydrocarbures présents dans un bassin sédimentaire, ledit procédé comprenant au moins la mise en oeuvre du procédé pour mettre à jour ledit modèle stratigraphique dudit bassin selon l'une des revendications 1 à 8, et dans lequel, à partir au moins dudit modèle stratigraphique mis à jour, on détermine un schéma d'exploitation dudit bassin comprenant au moins une implantation d'au moins un puits injecteur et/ou d'au moins un puits producteur, et on exploite lesdits hydrocarbures dudit bassin au moins en forant lesdits puits de ladite implantation et en les équipant d'infrastructures d'exploitation.

**Patentansprüche**

1. Verfahren, das durch einen Computer umgesetzt wird, zur Aktualisierung eines stratigraphischen Modells eines Sedimentbeckens auf der Grundlage von Messungen, die an dem Becken vorgenommen werden, mit Hilfe einer stratigraphischen Simulation, die auf einem Computer und anhand von Werten von Parametern der stratigraphischen Simulation ausgeführt wird, wobei die stratigraphische Simulation darauf abzielt, Sedimentprozesse, die das Becken von einer früheren geologischen Zeit bis zur aktuellen Zeit beeinflusst haben, nachzubilden, wobei die Parameter der stratigraphischen Simulation einen für die Sedimentierung verfügbaren Raum, der mit tektonischen und/oder eustatischen Bewegungen und der mechanischen Verdichtung der Sedimente verbunden ist, eine Zufuhr von Sedimenten in das Becken, entweder durch die Grenzen oder mittels einer In-situ-Produktion oder -Ausfällung, und einen Transport der Sedimente in den verfügbaren Raum beinhalten, **dadurch gekennzeichnet, dass** mindestens die folgenden Schritte angewendet werden:

A) Durchführen von Messungen physikalischer Größen in Bezug auf das Becken mit Hilfe von Sensoren, wobei die Messungen mindestens Bohrlochmessungen und seismische Messungen beinhalten;

B) anhand der Messungen, Bestimmen mindestens einer ersten räumlichen Verteilung von Werten eines Attributs, das für die Stratigraphie des Beckens repräsentativ ist, und Bestimmen eines ersten klassifizierten Bildes in Bezug auf die erste räumliche Verteilung mit Hilfe einer Klassifizierungsmethode, um die Werte des Attributs der ersten räumlichen Verteilung in mindestens zwei Klassen zu gruppieren;

C) mit Hilfe der stratigraphischen Simulation, die mit den Werten der Parameter der Simulation ausgeführt wird, Bestimmen eines stratigraphischen Modells;

D) auf dieser Basis, Herleiten mindestens einer zweiten räumlichen Verteilung von Werten des Attributs, das für die Stratigraphie des Beckens repräsentativ ist, und Bestimmen eines zweiten klassifizierten Bildes in Bezug auf die zweite räumliche Verteilung mit Hilfe der Klassifizierungsmethode, um die Werte des Attributs der zweiten räumlichen Verteilung gemäß den mindestens zwei Klassen des ersten klassifizierten Bildes zu gruppieren;

E) Bestimmen einer Verteilung von lokalen Unterschieden zwischen dem ersten und zweiten klassifizierten Bild und Modifizieren eines Werts mindestens eines der Parameter der stratigraphischen Simulation, um eine Zielfunktion, die anhand mindestens der Verteilung der lokalen Unterschiede gebildet wird, zu minimieren;

F) Aktualisieren des stratigraphischen Modells durch Wiederholen mindestens des Schritts C) mit den modifizierten Werten der Simulationsparameter.

2. Verfahren nach Anspruch 1, wobei das stratigraphische Modell in Schritt F) aktualisiert wird, indem die Sequenz der Schritte C), D) und E) wiederholt wird, bis die Zielfunktion mindestens ein vordefiniertes Kriterium erfüllt.

3. Verfahren nach einem der vorhergehenden Ansprüche, wobei die zweite räumliche Verteilung der Werte des Attributs in einem räumlichen Träger definiert ist, der sich von dem räumlichen Träger der ersten räumlichen Verteilung der Werte des Attributs unterscheidet, und wobei mindestens die zweite räumliche Verteilung der Werte des Attributs erneut abgetastet wird, damit die erste und die zweite räumliche Verteilung der Werte des Attributs in einem identischen räumlichen Träger definiert sind.

4. Verfahren nach einem der vorhergehenden Ansprüche, wobei die Zielfunktion anhand mindestens einer gewichteten Summe der lokalen Unterschiede zum Quadrat, die in jedem der Pixel des ersten und zweiten klassifizierten Bildes beobachtet werden, gebildet wird.

5. Verfahren nach Anspruch 3 und 4 in Kombination, wobei die Zielfunktion ferner einen Fehlerterm beinhaltet, der mit der Neuabtastung mindestens der zweiten räumlichen Verteilung der Werte des Attributs verbunden ist.

6. Verfahren nach einem der vorhergehenden Ansprüche, wobei das Attribut, das für die Stratigraphie repräsentativ ist, aus der Lithofazies, der Dicke einer stratigraphischen Einheit, der mittleren Sandkonzentration in einer stratigraphischen Einheit, der mittleren Tonkonzentration in einer stratigraphischen Einheit ausgewählt wird.

7. Verfahren nach einem der vorhergehenden Ansprüche, wobei die Klassifizierungsmethode aus Folgendem ausgewählt wird: der k-Means-Methode, der Methode der spektralen Partitionierung, der Methode der selbstorganisierenden Karten oder aber der Methode durch hierarchische Gruppierung.

8. Verfahren nach einem der vorhergehenden Ansprüche, wobei der Hausdorff-Abstand verwendet wird, um die Verteilung der lokalen Unterschiede zu bestimmen.

9. Computerprogrammprodukt, das aus einem Kommunikationsnetzwerk heruntergeladen werden kann und/oder auf einem computerlesbaren Medium aufgezeichnet ist und/oder durch einen Prozessor ausführbar ist und das Programmcodeanweisungen für die Umsetzung des Verfahrens nach einem der vorhergehenden Ansprüche beinhaltet, wenn das Programm auf einem Computer ausgeführt wird.

10. Verfahren zum Abbauen von Kohlenwasserstoffen, die in einem Sedimentbecken vorhanden sind, wobei das Verfahren mindestens die Umsetzung des Verfahrens zur Aktualisierung des stratigraphischen Modells des Beckens nach einem der Ansprüche 1 bis 8 beinhaltet und wobei anhand mindestens des aktualisierten stratigraphischen Modells ein Abbauplan für das Becken bestimmt wird, der mindestens ein Layout mindestens einer Injektionsbohrung und/oder mindestens einer Produktionsbohrung beinhaltet, und die Kohlenwasserstoffe des Beckens mindestens durch das Bohren der Bohrungen des Layouts und deren Ausrüstung mit Abbauinfrastruktur abgebaut werden.

**Claims**

1. Computer-implemented method for updating a stratigraphic model of a sedimentary basin depending on measurements made on said basin, by means of a stratigraphic simulation executed on a computer and on the basis of values of parameters of said stratigraphic simulation, said stratigraphic simulation aiming to simulate sedimentary processes having affected the basin from a prior geological time until the current time, said parameters of said stratigraphic simulation comprising a space available for sedimentation, which space is related to tectonic and/or eustatic movements and to mechanical compaction of sediments, a supply of sediments to said basin, either through the boundaries, or through in situ precipitation or production, and transportation of said sediments in said available space, **characterized in that** at least the following steps are applied:

   A) measurements of physical quantities relative to said basin are made by means of sensors, said measurements comprising at least well-log measurements and seismic measurements;
   B) on the basis of said measurements, at least a first spatial distribution of values of an attribute representative of said stratigraphy of said basin is determined, and a first classified image relative to said first spatial distribution is determined by means of a classification method, so as to group said values of said attribute of said first spatial distribution into at least two classes;
   C) by means of said stratigraphic simulation executed with said values of said parameters of said simulation, a stratigraphic model is determined;
   D) therefrom, at least a second spatial distribution of values of said attribute representative of said stratigraphy of said basin is determined, and a second classified image relative to said second spatial distribution is determined by means of said classification method, so as to group said values of said attribute of said second spatial distribution into said at least two classes of said first classified image;
   E) a distribution of local dissimilarities between said first and second classified images is determined, and a value of at least one of said parameters of said stratigraphic simulation is modified in such a way as to minimize an objective function formed on the basis at least of said distribution of said local dissimilarities;
   F) said stratigraphic model is updated by repeating at least step C) with said modified values of said simulation parameters.

2. Method according to Claim 1, wherein said stratigraphic model is updated in step F) by repeating the sequence of steps C), D) and E) until said objective function meets at least one predefined criterion.

3. Method according to one of the preceding claims, wherein said second spatial distribution of said values of said attribute is defined on a spatial support different from the spatial support of said first spatial distribution of said values of said attribute, and wherein at least said second spatial distribution of said values of said attribute is resampled so that said first and second spatial distributions of said values of said attribute are defined on an identical spatial support.

4. Method according to one of the preceding claims, wherein said objective function is formed on the basis at least of a weighted sum of said local dissimilarities to the power of two observed in each of the pixels of said first and second classified images.

5. Method according to Claims 3 and 4 in combination, wherein said objective function further comprises an error term related to said resampling of at least said second spatial distribution of said values of said attribute.

6. Method according to one of the preceding claims, wherein said attribute representative of said stratigraphy is chosen from the lithofacies, the thickness of a stratigraphic unit, the average concentration of sand in a stratigraphic unit, the average concentration of clay in a stratigraphic unit.

7. Method according to one of the preceding claims, wherein said classification method is chosen from: the k-means method, the spectral clustering method, the self-organizing map method, or even the hierarchical clustering method.

8. Method according to one of the preceding claims, wherein the Hausdorff distance is used to determine the distribution of the local dissimilarities.

9. Computer program product that is downloadable from a communication network and/or recorded on a medium that is readable by computer and/or executable by a processor, comprising program code instructions for implementing the method according to one of the preceding claims, when said program is executed on a computer.

10. Method for extracting hydrocarbons present in a sedimentary basin, said method comprising at least implementing the method for updating said stratigraphic model of said basin according to one of Claims 1 to 8, and wherein, on the basis at least of said updated stratigraphic model, an extraction scheme is determined for said basin, said extraction scheme comprising at least a placement of at least one injection well and/or at least one production well, and said hydrocarbons of said basin are extracted at least by drilling said wells of said placement and equipping them with extraction infrastructure.

[Fig 1]

[Fig 2]

[Fig 3]

[Fig 4]

[Fig 5]

[Fig 6]

[Fig 7]

[Fig 8]

[Fig 9]

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2776393 A
- EP 2447467 A1
- US 4679174 A
- EP 3016900 A1
- EP 3104199 A1

**Littérature non-brevet citée dans la description**

- **L. SAIIDA ; D. GUÉRILLOT.** *Méthode pour former automatiquement un modèle simulant la structure stratigraphique d'une zone souterraine.,* 1998
- **K. CHARVIN ; K. GALLAGHER ; G. L. HAMPSON ; R. LABOURDETTE.** A Bayesian approach to inverse modeling of stratigraphy, part 1: method. *Basin Research,* 2009, vol. 21, 5-25
- **O. FALIVENE ; A. FRASCATI ; S. GESBERT ; J. PICKENS ; Y. HSU ; A. ROVIRA.** Automatic calibration of stratigraphic forward models for predicting réservoir présence in exploration. *AAPG Bulletin,* 2014, vol. 98 (9), 1811-1835
- **E. BAUDRIER ; G. MILLON ; F. NICOLIER ; S. RUAN.** Binary image comparison with local dissimilarity quantification. *Pattern Recognition,* 2008, vol. 41 (5), 1461-1478
- **C.-H. KOECK ; G. BOURDAROT ; G. AL-JEFRI ; F. H. NADER ; R. RICHET ; A. BARROIS.** Improving a numerical sequence stratigraphic model through a global sensitivity analysis; Giant Carbonate Offshore Field, Abu Dhabi. *SPE-177758-MS, Abu Dhabi International Petroleum Exhibition and Conférence,* 2015
- **T. DUAN.** Similarity measure of sedimentary successions and its application in inverse stratigraphie modeling. *Pet. Sci.,* 2017, vol. 14, 484-492
- **I. S. MOLCHANOV ; P. TERAN.** Distance transforms for real-valued functions. *J. Math. Anal. Appl.,* 2003, vol. 278, 472-484
- **D. MCKAY.** Information theory, inference and learning algorithms. Cambridge University Press, 2003
- **NG A.Y. ; JORDAN M.I. ; WEISS Y.** On spectral clustering: Analysis and an algorithm. *Advances in Neural Information Processing Systems 14,* 2002, vol. 1,2, 849-856
- **KOHONEN T.** Self-Organizing Maps. Springer, 2001, 525
- **GRUS J.** K-means and hierarchical clustering with Python. *O'Reilly,* 2016
- **D. SINOQUET ; F. DELBOS.** Adapted nonlinear optimization method for production data and 4D seismic inversion. *Proceedings of ECMOR XI conférence,* Septembre 2008
- **D.R. JONES ; M. SCHONLAU ; W.J. WELCH.** Efficient Global Optimization of Expensive Black-Box Functions. *Journal of Global Optimization,* 1998, vol. 13, 455-492
- **RAFAEL SOUZA ; DAVID LUMLEY ; JEFFREY SHRAGGE ; ALESSANDRA DAVOLIO ; DENIS JOSÉ SCHIOZER.** Analysis of time-lapse seismic and production data for réservoir model classification and assessment. *Journal of Geophysics and Engineering,* Août 2018, vol. 15 (4), 1561-1587, https://doi.org/10.1088/1742-2140/aab287
- **BAUR, FRIEDEMANN ; KATZ, BARRY.** Some practical guidance for petroleum migration modeling. *Marine and Petroleum Geology.,* 2018, vol. 93
- **SCHLUMBERGER.** *User guide Petromod petroleum systems modeling software,* 01 Janvier 2012